# EUROPEAN PATENT APPLICATION

(11) **EP 4 651 197 A1**
(43) Date of publication of application: **19.11.2025**
(21) Application number: 24175413.4
(22) Date of filing: 13.05.2024
(51) Int. Cl.: H01L 23/00

(54) **SILVER COATED COPPER WIRE**

(71) Applicant: Heraeus Electronics GmbH & Co. KG, 63450 Hanau (DE)
(72) Inventor: Ditzel, Eckhard, 63450 Hanau (DE); Scharf, Juergen, 63450 Hanau (DE); Krüger, Frank, 63450 Hanau (DE); Kersting, Christian, 63450 Hanau (DE)
(74) Representative: Heraeus IP

(57) **Abstract**

The invention relates to a wire, preferably for bonding in power electronics, comprising a copper core with a surface and a coating layer superimposed over the surface of the copper core, wherein the coating layer comprises silver, wherein the aspect ratio between the shortest path and the longest path through the wire in any cross-sectional view is in the range of 0.8 to 1.0, wherein the wire has a diameter in the range of 100 µm to 600 µm and wherein in a cross-sectional view of the wire the area share of the coating layer is in the range of 10 to 60 %, based on the total area of the cross-section of the wire. The invention further relates to a process to manufacture such a wire, to a wire obtainable by said process, to an electronic assembly comprising at least two electronic elements and at least aforementioned wire, and to a process of connecting two elements through afore mentioned wire by wedge-wedge-bonding. The invention further relates to an electronic assembly comprising a bonded wire with a copper core and a silver comprising coating layer, wherein the coating layer comprises a first and a second thickness in a contact area of the bonded wire, and wherein the first thickness is smaller than the second thickness.

## Description

The invention relates to a wire, preferably for bonding in power electronics, comprising a copper core with a surface and a coating layer superimposed over the surface of the copper core, wherein the coating layer comprises silver, wherein in a cross-sectional view of the wire the area share of the coating layer is in the range of 10 to 60 %, based on the total area of the cross-section of the wire, and wherein the aspect ratio between the shortest path and the longest path through the wire in any cross-sectional view is in the range of 0.8 to 1.0, and wherein the wire has a diameter in the range of 100 µm to 600 µm. The invention further relates to a process for making a wire, to a wire obtainable by said process, to an electronic assembly comprising at least two electronic elements and at least aforementioned wire, to a device comprising said electronic assembly and to a process of connecting two elements through afore mentioned wire by wedge-wedge-bonding.

Bonding wires are electrical connecting elements in the field of assembly and connection technology for electronic modules. They are for example used in the manufacture of semiconductor devices for electrically interconnecting an integrated circuit and a printed circuit board during semiconductor device fabrication. Further, bonding wires are used in power electronic applications to electrically connect transistors, diodes and the like with pads or pins of a housing. In the field of power electronics, thick bonding wires and bonding ribbons are used for electrical connections in power modules. The high currents in this field require large cross-sections of the bonding wires and ribbons compared to cross-sections as found in thinner bonding wires in the field of microelectronics.

While bonding wires were made from gold in the beginning, nowadays less expensive materials are used such as copper or aluminium. Wires made of aluminium can be easily wedge-wedge-bonded applying only low forces, but their electrical conductivity is inferior compared to copper wires.

Wedge bonding is a method during which one end of the bonding wire is pressed by using a wedge bonding tool onto the area to be bonded, typically a bond pad which provides a contact surface of an electronic module. By using a short ultrasonic pulse, an electrical connection between the bonding wire and the module carrying the bond pad is formed. Subsequently, the bonding tool may move from the first bonding point along with the bonding wire to a second bonding point on the contact surface. The bonding process is repeated here, whereby the bonding wire is additionally cut off.

Copper wires provide very good electric and thermal conductivity, but wedge-bonding of such wires has its challenges compared to wires made of aluminium. Moreover, copper wires are susceptible to oxidation. To overcome this problem, wire development has been directed to bonding wires having a core and a protective shell, which is, e.g., a coating layer. As core material, copper or gold may be chosen because of high electrical conductivity. With regard to the coating layer, aluminium has also been applied. These core-shell bonding wires combine especially the high conductivity of copper wires with the advantageous bonding ability of aluminium wires. Aluminium coated copper wires are especially suitable for wedge-wedge-bonding applications. However, with the rise of new semiconductor materials, in particular WBG (wide bandgap) semiconductors like SiC and GaN, demanding higher operating temperatures than previous semiconductor generations over 200°C, this material combination faces problems, in particular an accelerated migration between the different materials resulting in a shorter lifetime of the assembly. Thus, there is an ongoing need for further improving bonding wire technology with regard to the bonding wire itself and the bonding processes.

Bonding wires suitable to be used in a power assembly through which large currents flow such as a motor or the like, need to have a minimal diameter of at least 100 µm to withstand high temperatures and/or the high current densities of operation. Such wires are typically bonded by wedge bonding to the respective substrate. This technique poses different challenges and requirements to the bonding wire in comparison to ball bonding, which is typically applied for thin wires with a diameter well below 100 µm. During wedge bonding, the bonding wire is heated and pressed with a certain force onto the contact pads of the electronic elements to be bonded, for example semiconductor substrates or housings. If the required force is too high, the surface of the substrate and especially the semiconductor can be damaged. Thus, it is desired to reduce the forces during the wedge bonding process while still ensuring a strong wire bond in order to minimize the risk to damage the semiconductor or the substrate surface.

With respect to wire geometry, most common are bonding wires of circular cross-section and bonding ribbons which have a more or less rectangular cross-section. Both types of wire geometries have their advantages making them useful for specific applications. Thus, both types of geometry have their share in the market. For example, bonding ribbons have a larger contact area for a given cross-sectional area. However, bending of the ribbons is limited and orientation of the ribbon must be observed when bonding in order to arrive at acceptable electrical contact between the ribbon and the element to which it is bonded. Turning to bonding wires, these are more flexible to bending. However, bonding involves either soldering or larger deformation of the wire in the bonding process, which may cause harm or even destroy the bonding pad and underlying electric structures of the element, which is bonded thereto.

Accordingly, it is an object of the invention to provide improved wires.

It is a further object of the invention to provide a wire which exhibits excellent bondability. Thus, it is an object to provide a wire which is in particular suitable for wedge bonding with a low bonding force. In the context of the present invention, a good wedge bondability is to be understood as the property of a bonding wire to obtain good performance in a bonding process with a low bonding force applied and at the same time a high bonding strength of the obtained wedge bond. The wire shall be usable with standard bonding technology without adaption of established processes.

It is a further object of the invention to provide a wire which is suitable for operation temperatures over 200 °C, or even over 225 °C.

Another object of the invention is to provide a wire which has good processing properties, and which has no specific needs when interconnecting, thus saving costs.

It is also an object of the invention to provide a wire which has excellent electrical and thermal conductivity.

It is a further object of the invention to provide a wire which exhibits an improved reliability.

It is another object of the invention to provide a wire which has improved resistance to corrosion and/or oxidation.

It is another object to provide a novel wire especially suited for contacting WBG semiconductors, especially by wedge bonding, which assures extended lifetime over conventional wires.

It is a further object to provide improved electronic assemblies, in particular for power electronics, which have an extended lifetime compared to conventional assemblies in which the electrical elements are interconnected by copper wires or aluminium coated copper wires.

It is another object to provide improved electronic assemblies, in particular for power electronics, which operate at higher electrical current flow than conventional assemblies in which bonding is provided by copper wires or aluminium coated copper wires.

It is another object of the invention to provide such improved electronic assemblies which have the same dimensions and similar semiconductor design as aforementioned conventional assemblies. It is another object to provide means for manufacturing such improved electrical assemblies on production lines originally designed for the manufacture of conventional electronic assemblies. This would minimize cost for implementing the improved technology.

Surprisingly, wires of the present invention have been found to solve at least one of the objects mentioned above. Further, a process for manufacturing these wires has been found which overcomes at least one of the challenges of manufacturing wires. Further, electronic assemblies comprising the wires of the invention were found to have a stronger bond connection and can withstand more temperature cycles and higher temperature differences be more reliable at the interface between the wire according to the invention and other electronic elements.

A contribution to the solution of at least one of the above objects is provided by the subject matters of the category-forming claims, whereby the dependent sub-claims of the category-forming independent claims representing preferred aspects of the invention, the subject matter of which likewise makes a contribution to solving at least one of the objects mentioned above.

A first aspect of the invention is a wire comprising:
a copper core with a surface; and
a coating layer superimposed over the surface of the copper core, wherein the coating layer comprises silver,
wherein the aspect ratio between the shortest path and the longest path through the wire in a cross-sectional view is in the range of 0.8 to 1.0, the wire has a diameter in the range of 100 µm to 600 µm and wherein the area share of the coating layer in a cross-sectional view of the wire is in the range of 10 to 60 %, based on the total area of the cross-section of the wire.

The wire is preferably a bonding wire for bonding in power electronics. Preferably, the wire is a one-piece object. The criteria for aforementioned cross-sectional view and the diameter should be met within at least 80 %, preferably 90 % of the longitudinal extension of the wire. It is to be understood, that if not referred to otherwise, the geometrical parameters are defined for a wire which is not bonded to an electronic element such as e.g. a semiconductor or a substrate.

The wire has a diameter in the range of 100 µm to 600 µm, preferably in the range of 150 µm to 550 µm, or of 200 µm to 500 µm.

The aspect ratio between the shortest path and the longest path through the wire in a cross-sectional view is in the range of 0.8 to 1.0, preferably from 0.9 to 1.0, or from 0.9 to 0.99, or from 0.95 to 0.99.

The term "a cross-sectional view" in the present context refers to a view of a cut through the wire, wherein the plane of the cut is perpendicular to the longitudinal extension of the wire. The cross-sectional view can be found at any position on the longitudinal extension of the wire.

The "longest path" through the wire in a cross-section is the longest distance which can be laid through the cross-section of the wire within the plane of the cross-sectional view. The "shortest path" through the wire in a cross-section is the longest distance perpendicular to the longest path within the plane of the cross-sectional view defined above. If the wire has a perfect circular cross-section, then the longest path and the shortest path share the same value.

The term "diameter" is the arithmetic mean of all geometric diameters of any plane and in any direction, wherein all planes are perpendicular to the longitudinal extension of the wire.

Preferably, the wire of the invention has a substantially circular shape in a cross-sectional view of the wire.

According to another aspect of the invention, the diameter of the copper core is in the range of 70 to 500 µm, preferably from 100 to 400 µm, or from 150 to 350 µm, or from 200 to 300 µm, each determined in a cross-sectional view of the wire.

The copper core according to the invention preferably comprises at least 95 % by weight of elemental copper (Cu), preferably at least 98 % by weight, even more preferred at least 99 % by weight, most preferred less than 99.99 % by weight, each based on the total weight of the copper core.

Preferably, the copper core comprises less than 100 ppm further components, yet more preferred less than 50 ppm. In other words, the copper core preferably consists of copper and inevitable impurities. The low amount of these further components ensures good electrical properties of the wire. In the present context, the further components, often also referred as "inevitable impurities", are minor amounts of chemical elements and/or compounds which originate from impurities present in the raw materials used or from the manufacturing process which produced the wire. Examples of such further components are: Ni, Mn, Pt, Cr, Ca, La, Al, B, Zr, Ti, S, Fe. Further components present in the copper core are usually not added separately.

The "surface" of the copper core of an uncoated copper wire is the wire/air interface.

The "surface" of the copper core of a coated, possibly annealed wire is defined to be the virtual limit of the copper core around its center, which virtual limit is where the concentration of Cu deviates more than 3 %-wt. from the concentration of Cu at the center of the core, which center is defined by the intersection of the shortest and the longest path both as defined above.

The core of the wire is a homogeneous region of bulk material. Since any bulk material always has a surface region which might exhibit different properties to some extent, the properties of the core of the wire are understood as properties of the homogeneous region of bulk material. The surface of the bulk material region can differ in terms of morphology, composition (e.g. sulfur, chlorine and/or oxygen content) and other features. The surface is an interface region between the copper core and the coating layer superimposed on the copper core. Typically, the coating layer is completely superimposed on the copper core's surface. In the region of the wire between its core and the coating layer superimposed thereon a combination of materials of both, the core and the coating layer, can be present. This layer may also be referred to as the "intermediate layer".

The wire comprises a coating layer, which comprises silver superimposed over the surface of the copper core. The term "superimposed" in the context of this invention is used to describe the relative position of a first item, e.g. a copper core, with respect to a second item, e.g. a coating layer. Possibly, further items, such as an intermediate layer, may be arranged between the first and the second item. Preferably, the coating layer is at least partially superimposed over the surface of the copper core, e.g. for at least 30 %, 50 %, 70 % or for at least 90 % with respect to the total surface of the copper core.

The coating layer comprising silver is preferably selected from the group consisting of silver, silver alloys or a combination of the two.

Preferably, the coating layer comprises at least 85 % by weight of elemental silver (Ag), preferably at least 90 % by weight, more preferred at least 95 % by weight, even more preferred at least 98 % by weight, each based on the total weight of the coating layer.

Preferably, the coating layer comprises less than 1000 ppm of further components, yet more preferred less than 500 ppm. The low amount of these further components ensures good electrical properties of the wire. In the present context, the further components, often also referred as "inevitable impurities", are minor amounts of chemical elements and/or compounds which originate from impurities present in the raw materials used or from the manufacturing process which produced the wire, in particular the raw materials used during the coating process. In other words, the coating layer preferably consists of silver and inevitable impurities. Examples of such further components are: Ni, Mn, Pt, Cr, Ca, La, Al, B, Zr, Ti, S, Fe. Further components present in the coating layer are usually not added separately.

According to another aspect of the invention, the thickness of the coating layer is in the range of 5 to 60 µm, preferably from 10 to 50 µm, preferably from 15 to 40 µm, or from 20 to 35 µm, each determined in a cross-sectional view of the wire. The aforementioned criteria for thickness of the coating layer should be met within at least 80 %, preferably 90 % of the longitudinal extension of the wire.

The term "thickness" in the context of this invention is used to define the size of a layer in perpendicular direction to the longitudinal axis of the wire, which layer is at least partially superimposed over the surface of the copper core.

All of aforementioned dimensions of length, e.g. thickness, diameter, longest path, shortest path are determined in a cross-sectional view as defined above.

The cross-sectional area share of the coating layer in a cross-sectional view is in the range of 10 to 60 %, preferably from 15 to 50 %, or 20 to 45 %, or 25 to 40 %, each based on the total area of the cross-section of the wire. The area ratios of the copper core and the coating layer are important for the properties of the strength and bondability of the wire. Such a cross-sectional area share ensures a suitable bondability and a high strength of the resulting bond.

The coating layer has two "surfaces". The first "surface" of the coating layer is the wire/air interface. The second "surface" of the coating layer is defined to be the virtual limit of the coating layer defined by the concentration of Ag deviating more than 3 %-wt. from the concentration of Ag at the bulk region of coating layer. The bulk region is defined to be the region which is to be in equal distance between the first and the second "surface" of the coating layer.

Due to diffusion phenomena, distinct borders between the copper core and the coating layer may disappear during the production (for example introduced by heat treatment steps) and/or storage of the wires according to the invention. In particular, material from the copper core may diffuse into the material of the coating layer and material from the coating layer may diffuse into the material of the copper core. This may lead, for example, to the formation of alloys or intermetallic phases that are situated between the copper core and the coating layer. These alloys or intermetallic phases usually consist of elements that are present in the material of the copper core and in the material of the coating layer and usually comprise a gradient, whereby the content of the element of the material of the copper core decreases from the center of the wire core towards the surface of the wire, and the content of the element of the material of the coating layer decreases from the surface or surface near regions of the wire towards the inside of the wire. Such diffusion phenomena may lead to the presence of an intermediate layer.

According to another aspect of the invention, an intermediate layer is arranged between the copper core and the coating layer. The term "intermediate layer" in the context of this invention is a region of the wire, between the copper core and the coating layer. In this region, material as in the core as well as material as in the coating layer may be present in combination, for example, in form of at least one intermetallic phase.

Preferably, the intermediate layer comprises only material of the copper core and material of the coating layer. According to a preferred aspect of the invention, the intermediate layer is arranged between the core and the coating layer, wherein the intermediate layer is adjacent to the copper core and adjacent to the coating layer. Such an intermediate layer enhances the adhesion between copper core and coating layer and ensures the functionality of the wire.

Preferably, the intermediate layer comprises less than 800 ppm further components, yet more preferred less than 500 ppm. In other words, the intermediate layer preferably consists of copper, silver and inevitable impurities.

In preferred embodiments, the intermediate layer of the wire is defined to be the region of the wire between the copper core and the coating layer in which the concentration of Cu deviates more than 3 %-wt. from the concentration of Cu in the copper core, based on the total weight of the copper core, and in which the concentration of Ag deviates more than 3 %- wt. from the concentration of Ag in the coating layer, based on the total weight of the coating layer. In other words, the concentration of copper in the intermediate layer is preferably at least 3 %-wt. lower than the concentration of Cu in the copper core and the concentration of silver in the intermediate layer is preferably at least 3 %-wt. lower than the concentration of Ag in the coating layer, based on the total weight of the coating layer.

Preferably, the intermediate layer does not comprise any materials and/or elements which are not present in the copper core or the coating layer.

The intermediate layer may comprise at least one intermetallic phase comprising material of the copper core and material of the coating layer.

Preferably, the intermediate layer comprises a concentration gradient of copper from the copper core towards the coating layer and a concentration gradient of silver from the coating layer towards the copper core in a direction perpendicular to the longitudinal axis of the wire. A concentration gradient is to be understood as a decrease in the concentration of the respective element. Such concentration gradients can further enhance the adhesion of the coating layer on the surface of the copper core, makes the production easier and raises the productivity of the wire.

According to another aspect of the invention, the area share of the intermediate layer in any cross-sectional view of the wire is in the range of 0.05 to 15 %, preferably from 0.1 to 10 %, each based on the total area of the cross-section of the wire.

According to another aspect of the invention, the thickness of the intermediate layer is in the range of 0.05 to 5 µm, preferably from 0.1 to 3 µm. The aforementioned criteria for thickness of the intermediate layer should be met within at least 80 %, preferably 90 % of the longitudinal extension of the wire. Sometimes, deviations in the thickness of the intermediate layer may occur due to imperfections of the intermediate layer, e.g. pores.

Aforementioned dimensions, i.e. the thickness of the coating layer, the thickness of the intermediate layer, the diameter of the wire and of the copper core can be determined in a cross-sectional view of the wire, e.g. using light microscopy or scanning electron microscopy. In light microscopy, the copper core is colored in copper red, the coating layer is silvery and the intermediate layer is grey. The concentrations of copper and silver which were described above, can be determined using combined SEM/EDX (Scanning electron microscopy / energy dispersive X-ray spectroscopy).

A wire according to the invention may be manufactured by providing a wire precursor comprising a copper core and a silver coating layer with a larger diameter than the inventive wire and drawing the precursor to the final wire diameter. Preferably, the shaped wire is annealed in a further step.

Another aspect of the invention is a process for manufacturing a wire, comprising at least the following steps:
I.) providing a wire precursor comprising a copper core precursor with a surface and a coating layer precursor, which coating layer precursor is superimposed over the surface of the copper core precursor, wherein the coating layer precursor comprises silver, wherein in a cross-sectional view of the wire precursor the area share of the coating layer precursor is in the range of 10 to 60 %, based on the total area of the cross-section of the wire precursor, and
   wherein the aspect ratio between the shortest path and the longest path through the wire precursor in a cross-sectional view is in the range of 0.8 to 1.0;
II.) shaping the wire precursor, whereby the wire is obtained.

Aspects of the invention directed to the wire described above are also preferred aspects of the wire obtained by aforementioned process for manufacturing a wire.

Precursor items are items of pre-stages which have not reached the desired final dimensions and/or properties of the wire.

Preferably, the process comprises a subsequent step III.) in which the wire is annealed.

Preferably, the wire precursor has a diameter in the range of 0.3 to 5 mm, more preferred of 0.5 to 3 mm, or of 0.75 to 2 mm.

A wire precursor as in step I.) can be obtained by forming a silver coating layer precursor on at least part of the surface of a copper core precursor. A suitable copper core precursor may for example be a copper wire. Preferably the silver coating layer precursor is formed on 100 %, or from 80 to 100 %, or from 60 to 80 %, of the surface of the copper core precursor, each with respect to the total surface area of the copper core precursor. Numerous techniques for forming a silver coating layer on a copper surface and in particular on copper wire are known. Preferred techniques are plating, such as electroplating and electroless plating, deposition of silver from the gas phase such as sputtering, ion plating, vacuum evaporation and chemical vapor deposition, and deposition of silver from a melt. The wire precursor may also be obtained by a process during which a copper core precursor is enclosed in a silver tube and optionally drawn to a desired diameter and/or an optional subsequent annealing step.

The silver coating layer precursor is preferably applied by electroplating. Silver electroplating is performed making use of a silver electroplating bath, i.e. an electroplating bath that allows for a copper cathode surface to be electroplated with silver. In other words, the silver electroplating bath is a composition allowing for direct application of silver in elemental, metallic form onto a copper surface wired as cathode.

Electroplating application of the silver coating layer precursor is performed by guiding the copper core precursor as a cathode through the silver electroplating bath. The so obtained wire precursor exiting the silver electroplating bath may be rinsed and dried. The use of water as a rinsing medium is expedient, with alcohol and alcohol/water mixtures being further examples of rinsing media. The silver electroplating of the copper wire passing through the silver electroplating bath can take place at a direct voltage in the range of, for example, 0.2 to 20 V at a current in the range of, for example, 0.001 to 5 A, in particular 0.001 to 1 A or 0.001 to 0.2 A. Typical contact times may be in the range of, for example, 0.1 to 120 seconds, preferably 5 to 60 seconds. The current densities used in this context can be in the range of, for example, 0.01 to 150 A/dm². The silver electroplating bath may have a temperature in the range of, for example, 25 to 50 °C, preferably 30 to 40 °C.

The thickness of the silver coating layer precursor can be adjusted as desired essentially via the following parameters: chemical composition of the silver electroplating bath, contact time of the copper wire with the silver electroplating bath, current density. In this context, the thickness of the silver coating layer can generally be increased by increasing the concentration of the silver in the silver electroplating bath, by increasing the contact time of the copper wire employed as cathode and the silver electroplating bath, and by increasing the current density.

Pretreatment of the copper core precursor can be employed to adapt the surface roughness and/or to add a pattern to the surface of the copper core precursor. Numerous techniques are known to adapt the surface of the copper core precursor. Preferred techniques are cold roll forming, grinding and electrochemical grinding.

After the coating of the copper core precursor with the silver coating layer precursor, the wire precursor is obtained.

It is to be understood, that during the shaping step, the aspect ratio between the shortest path and the longest path through the wire precursor in a cross-sectional view is in the range of 0.8 to 1.0 are maintained such that the wire obtains a final aspect ratio between the shortest path and the longest path through in a cross-sectional view in the range of 0.8 to 1.0.

In step II.), the wire precursor is shaped. Shaping is preferably understood to mean a process in which a change in the shape of the work piece processed is attained without an attendant significant change in the mass of the work piece processed. A cutting process, for example, is not a shaping process, since the cutting process is associated with a reduction of the mass of the work piece processed by the mass of the severed part. Numerous techniques are known to shape the wire precursor. Preferred techniques are rolling, die drawing or the like. In the latter case the precursor item is drawn in several process steps until the desired cross-sectional shape and/or the desired diameter is reached. Such wire die drawing processes are well known to the person skilled in the art. Conventional tungsten carbide and diamond drawing dies may be employed and conventional drawing lubricants may be employed to support the drawing. Die drawing is particularly preferred. More preferably, the wire precursor is drawn in 3 to 20 steps, wherein in each step an elongation of the wire precursor of 6 to 18 % in length is performed. A slipping agent may be employed. Suitable slipping agents are numerous and known to the skilled person.

Numerous procedures are known in the art to anneal a wire or a wire precursor, e.g. annealing can be performed in both, a continuous or in a discontinuous process for example by a heat treatment in an oven or plasma annealing. In special applications, continuous and discontinuous processes may even be combined.

According to a preferred aspect of the invention, the annealing is performed by heating the wire precursor to a temperature in the range from 140 to 400 °C, preferably from 160 to 350 °C, or from 200 to 300 °C, or from 220 to 280 °C and the temperature is maintained for 30 minutes to 5 hours, preferably from 30 minutes to 3 hours. Then, the wire obtained by annealing the wire or wire precursor is cooled to room temperature. The cooling can be performed in various ways. One suitable way is to expose the wire to ambient air at ambient temperature upon leaving the heating zone. The cooling of the wire to room temperature (T = 20 °C) according to aforementioned procedure can be usually achieved within 24 hours. A quenching of the wire should be avoided, e.g. by immersion in cold water and the like. Accordingly, another aspect is a process in which the cooling of the wire upon leaving the heating zone is not performed by quenching of the wire.

Preferably, the annealing is done dynamically while the wire or wire precursor is moved through an annealing furnace and wound onto a spool after having left the furnace. According to another aspect of the invention the annealing is performed in a continuous process, more preferably in a tube furnace. Even more preferred the wire is drawn from the step of providing a wire precursor and the shaping and the annealing by a single drawing machine.

The speed of the wire during annealing in a tube furnace depends on the length of the tube of the tube furnace. As longer the tube, as higher speeds are feasible in order to obtain a certain exposure of energy to a piece of wire. Preferred lengths of tubes of tube furnaces are in the range of 0.8 to 2.5 m, or from 1 to 2 m, or of 1.5 to 2.5 m.

The temperature in the tube of the furnace can be adjusted to the speed or evaluated independently. Preferred temperatures in the tube are in the range of 150 to 600 °C, or from 200 to 600 °C, or from 250 to 550 °C. In general, the temperature is selected to be lower than the temperature at which at least one of the components or a mixture of at least two components present in the wire liquefies. For example, if partially soluble or insoluble two- or multi-components alloys are annealed, the eutectic temperature of the alloy should not be exceeded by the temperature in the oven.

According to another aspect of the invention, the temperature in the furnace is chosen to be at least 30 °C, or 50 °C, or 80 °C lower than the temperature at which at least one of the components or a mixture of at least two components of the wire liquefies.

According to another aspect of the invention the annealing speed is chosen in the range of 1 to 100 m/min, or from 5 to 30 m/min, or from 10 to 20 m/min.

According to another aspect of the invention, the annealing in the tube furnace may be performed in an inert atmosphere or a reducing atmosphere. This applies to both annealing in continuous as well as discontinuous processing. Numerous inert atmospheres as well as reducing atmospheres are known in the art. Of the known inert atmospheres, nitrogen is preferred. Of the known reducing atmospheres, hydrogen is preferred. Further, preferred reducing atmospheres are mixtures of nitrogen and hydrogen. Preferably, mixtures of nitrogen and hydrogen are preferred which are in the range of 90 to 98 %-Vol. nitrogen and of 10 to 2 Vol-% hydrogen, each referring to the total volume of the mixture. Preferred mixtures of nitrogen/hydrogen are equal to 90/10, 93/7, 95/5 and 97/3 Vol-%/Vol-%, each based on the total volume of the mixture. Applying reducing atmospheres in annealing is particularly preferred, if some parts of the surface of the wire are sensitive to oxidation by oxygen of the air, e.g. if copper of the wire is exposed to its surface.

According to another aspect of the invention, an intermediate layer is formed during annealing.

Another aspect of the invention is a wire obtainable by a as process defined above.

Another aspect of the invention is an electronic assembly comprising at least a wire according to the invention or a wire manufactured according to the invention.

Electronic assemblies shall be understood herein as electronic or power electronic subassemblies comprising at least one substrate (as circuit carrier), at least one semiconductor component (semiconductor) or, if applicable, at least one passive electronic component. Preferably, the electronic assembly is a power module.

Examples of substrates include IMS (insulated metal substrates), metal ceramic substrates, e.g. DCB substrates (direct copper-bonded substrates) or AMB substrates (active metal brazing substrates), PCBs (printed circuit boards), and leadframes.

Examples of semiconductor components include diodes, LEDs (light emitting diodes), dies (semiconductor chips), IGBTs (insulated-gate bipolar transistors), ICs (integrated circuits), and MOSFETs (metal-oxide-semiconductor field-effect transistors).

Preferably, the wire of the electronic assembly is bonded by wedge-wedge-bonding.

Preferably the electronic assembly comprises at least two electronic elements and the wire electronically connects the two electronic elements.

According to another aspect of the invention, at least one wire in the electronic assembly is connected to an electronic element of the electronic assembly by wedge-wedge bonding, preferably by ultrasonic wedge-wedge bonding.

Wedge bonding technology is known in the art and extensively described in the literature, e.g. in Shankara K. Prasad, "Advanced Wirebond Interconnection Technology", Kluwer Academic Publishers, 2004, ISBN 1-4020-7762-9, in particular chapter I (introduction) and chapter IV (process technology). During bond forming a certain force (typically measured in grams) is applied, supported by application of ultrasonic energy (typically measured in mA). The wire of the invention is in particular suitable for a bonding process with the application of relatively low bonding forces.

Another aspect of the invention is a process for manufacturing an electronic assembly comprising the steps of
I.) providing at least two electronic elements;
II.) providing a wire according to the invention or one of the embodiments thereto, or a wire obtained by a method according to the invention or one of the embodiments thereto;
III.) connecting the two electronic elements through the wire, wherein at least one of said connections is performed by wedge bonding.

In another preferred aspect of the invention, the electronic assembly comprises a first and a second bond pad and the wire is connected to the bond pads by wedge-wedge bonding.

Another aspect of the invention is a method for connecting an electronic assembly, comprising the steps of
I.) providing a wire according to the invention or one of the embodiments thereto, or a wire obtained by a method according to the invention or one of the embodiments thereto;
II.) providing an electronic assembly comprising a first bond pad and a second bond pad;
III.) bonding the wire provided in step I.) to the first bond pad of the electronic assembly by wedge bonding; and
IV.) bonding the wire of step I.) which is bonded to the first bond pad to the second bond pad of the electronic assembly by wedge bonding.

Preferably, step III.) and/or step IV.) are performed without the use of an inert gas or a forming gas. Forming gas is known in the art as a mixture of an inert gas like nitrogen with hydrogen, wherein the hydrogen content may provide for reduction reactions of oxidized wire material. In the sense of the invention, omitting of forming gas means that no reactive compounds like hydrogen is used.

Another aspect of the invention is the use of a wire according to the invention or of wire manufactured according to a process according to the invention in wedge-wedge bonding interconnections in an electronic assembly.

Another aspect of the invention is an electronic assembly, comprising an electronic element with a contact surface and at least a bonded wire, which is wedge-bonded to the contact surface in a contact area, wherein the bonded wire comprises
(i) a copper core with a surface, wherein the copper core has a diameter in the range of 70 to 500 µm; and
(ii) a coating layer superimposed over the surface of the copper core, wherein the coating layer comprises silver;

wherein the wire comprises at least one bonded section in the contact area and at least one free section, and wherein the aspect ratio between the shortest path and the longest path through the copper core of the wire in the bonded section and the free section in a cross-sectional view is in the range of 0.8 to 1.0,
wherein in a cross-section of the contact area perpendicular to the longitudinal length of the bonded wire the coating layer of the bonded wire has a first thickness T₁ and a second thickness T₂ along an axis A through the center of the copper core perpendicular to the contact surface in the bonded section,
wherein the first thickness T₁ is the thickness of the coating layer in contact with the contact surface in the contact area along said axis and the second thickness T₂ is the thickness of the coating layer on the opposite side of the copper core of said axis in a direction from the contact area to the copper core,
wherein the first thickness T₁ is smaller than the second thickness T₂.

During the wedge-bonding process, the wire is bonded to the contact surface of the electronic assembly and the bond is established in the contact area of the contact surface. The section of the wire which is in contact with the contact surface is the bonded section of the bonded wire. The bonded wire comprises at least one free section. It may be understood that the free section or free sections comprise the section or sections of the bonded wire, which are not bonded to the contact surface.

The bonded wire comprises
(i) a copper core with a surface, wherein the copper core has a diameter in the range of 70 to 500 µm; and
(ii) a coating layer superimposed over the surface of the copper core, wherein the coating layer comprises silver.

According to another aspect of the invention, the diameter of the copper core is in the range of 70 to 500 µm, preferably from 100 to 400 µm, or from 150 to 350 µm, or from 200 to 300 µm, each determined in a cross-sectional view of the wire.

The copper core according to the invention preferably comprises at least 95 % by weight of elemental copper (Cu), preferably at least 98 % by weight, even more preferred at least 99 % by weight, each based on the total weight of the copper core.

Preferably, the copper core comprises less than 100 ppm further components, yet more preferred less than 50 ppm. In other words, the copper core preferably consists of copper and inevitable impurities. The low amount of these further components ensures good electrical properties of the wire. In the present context, the further components, often also referred as "inevitable impurities", are minor amounts of chemical elements and/or compounds which originate from impurities present in the raw materials used or from the manufacturing process which produced the wire. Examples of such further components are: Ni, Mn, Pt, Cr, Ca, La, Al, B, Zr, Ti, S, Fe. Further components present in the copper core are usually not added separately.

The coating layer comprising silver is preferably selected from the group consisting of silver, silver alloys or a combination of the two. Preferably, the coating layer comprises at least 85 % by weight of elemental silver (Ag), preferably at least 90 % by weight, more preferred at least 95 % by weight, even more preferred at least 98 % by weight, each based on the total weight of the coating layer.

Preferably, the coating layer comprises less than 1000 ppm of further components, yet more preferred less than 500 ppm. The low amount of these further components ensures good electrical properties of the wire. In the present context, the further components, often also referred as "inevitable impurities", are minor amounts of chemical elements and/or compounds which originate from impurities present in the raw materials used or from the manufacturing process which produced the wire, in particular the raw materials used during the coating process. In other words, the coating layer preferably consists of silver and inevitable impurities. Examples of such further components are: Ni, Mn, Pt, Cr, Ca, La, Al, B, Zr, Ti, S, Fe. Further components present in the coating layer are usually not added separately.

According to another aspect of the invention, an intermediate layer is arranged between the copper core and the coating layer. The term "intermediate layer" in the context of this invention is a region of the wire, between the copper core and the coating layer. In this region, material as in the core as well as material as in the coating layer may be present in combination, for example, in form of at least one intermetallic phase.

Preferably, the intermediate layer comprises only material of the copper core and material of the coating layer. According to a preferred aspect of the invention, the intermediate layer is arranged between the core and the coating layer, wherein the intermediate layer is adjacent to the copper core and adjacent to the coating layer. Such an intermediate layer enhances the adhesion between copper core and coating layer and ensures the functionality of the wire.

Preferably, the intermediate layer comprises less than 800 ppm further components, yet more preferred less than 500 ppm. In other words, the intermediate layer preferably consists of copper, silver and inevitable impurities.

In preferred embodiments, the intermediate layer of the wire is defined to be the region of the wire between the copper core and the coating layer in which the concentration of Cu deviates more than 3 %-wt. from the concentration of Cu in the copper core, based on the total weight of the copper core, and in which the concentration of Ag deviates more than 3 %- wt. from the concentration of Ag in the coating layer, based on the total weight of the coating layer. In other words, the concentration of copper in the intermediate layer is preferably at least 3 %-wt. lower than the concentration of Cu in the copper core, and the concentration of silver in the intermediate layer is preferably at least 3 %-wt. lower than the concentration of Ag in the coating layer, based on the total weight of the coating layer.

Preferably, the intermediate layer does not comprise any materials and/or elements which are not present in the copper core or the coating layer.

The intermediate layer may comprise at least one intermetallic phase comprising material of the copper core and material of the coating layer.

Preferably, the intermediate layer comprises a concentration gradient of copper from the copper core towards the coating layer and a concentration gradient of silver from the coating layer towards the copper core in a direction perpendicular to the longitudinal axis of the wire. A concentration gradient is to be understood as a decrease in the concentration of the respective element. Such concentration gradients can further enhance the adhesion of the coating layer on the surface of the copper core, makes the production easier and raises the productivity of the bonded wire.

According to another aspect of the invention, the area share of the intermediate layer in any cross-sectional view of the bonded wire is in the range of 0.05 to 15 %, preferably from 0.1 to 10 %, each based on the total area of the cross-section of the bonded wire.

According to another aspect of the invention, the thickness of the intermediate layer is in the range of 0.05 to 5 µm, preferably from 0.1 to 3 µm. The aforementioned criteria for thickness of the intermediate layer should be met within at least 80 %, preferably 90 % of the longitudinal extension of the bonded wire. Preferably, thickness of the intermediate layer in the bonded section and in the free section or the free section do not deviate by more than 10 % from each other, preferably by not more than 5 %.

Aforementioned dimensions, i.e. the thicknesses of the coating layer, the thickness of the intermediate layer, the diameter of the bonded wire and of the copper core can be determined in a cross-sectional view of the wire, e.g. using light microscopy or scanning electron microscopy. In light microscopy, the copper core is colored in copper red, the coating layer is silvery and the intermediate layer is grey. The concentrations of copper and silver which were described above, can be determined using combined SEM/EDX (Scanning electron microscopy / energy dispersive X-ray spectroscopy).

The contact area of the electronic assembly is to be understood as the area of the contact surface, in which a physical connection is present between the bonded wire and the contact surface.

Preferably, the diameter of the contact area has at least the diameter of the bonded wire, preferably at least 1.2 times the diameter of the bonded wire. For example, the diameter of the contact area may be 1 to 1.8 times the diameter of the bonded wire, preferably 1.2 to 1.6 times. The diameter of the contact area is to be understood as the diameter in the center of the contact area perpendicular to the longitudinal axis of the bonded wire.

It has to be distinguished between the wire, i.e. the free wire which is provided before bonding and the bonded wire, i.e. the wire which is wedge-bonded to the contact surface of the electronic module. In preferred embodiments, a wire according to the invention is employed as a bonding wire. In other words, an inventive wire is bonded in an electronic module by at least one wedge-bond.

During the wedge-bonding process, the wire is pressed against the contact surface which causes a deformation of the wire. It is advantageous, that the initially substantially circular cross-section of the copper core is not deformed during this process. According to the invention, the aspect ratio between the shortest path and the longest path through the copper core of the wire in the bonded section and in the free section or the free sections in a cross-sectional view is in the range of 0.8 to 1.0. In other words, the copper core of the bonded wire of the electronic module according to the invention has a substantially circular cross section in the bonded and the free section. Such a profile results in an optimized contact of the bonded wire to the contact surface.

Preferably, the aspect ratio between the shortest path and the longest path through the copper core of the wire in the bonded section and in the free section or the free sections in a cross-sectional view do not deviate by more than 10 % from each other, preferably by not more than 5 %.

The coating of the bonded wire has a first thickness T₁ and a second thickness T₂ along an axis A through the center of the copper core perpendicular to the contact surface in the bonded section in a cross-section of the contact area perpendicular to the longitudinal length of the bonded wire.

The first thickness T₁ is the thickness of the coating in contact with the contact surface in the contact area along the axis A. In other words, the first thickness is the thickness of the coating between the contact surface and the copper core in the contact area.

In preferred embodiments, the first thickness T₁ is in the range between 1 to 50 µm, preferably between 2 to 40 µm. The presence of a coating layer in this area has been shown to be advantageous for the electrical connection of the bonded wire and enhances the reliability of the bond.

The second thickness T₂ is the thickness on the opposite side of the copper core of the axis A in a direction from the contact area to the copper core. In other words, the second thickness is the thickness of the coating layer above the copper core in the contact area.

In preferred embodiments, the second thickness T₂ is in the range between 8 to 80 µm, preferably between 10 to 60 µm.

The first thickness T₁ is smaller than the second thickness T₂.

In preferred embodiments, the wire has a coating layer with an initial thickness in the range of 5 to 60 µm before wedge bonding, preferably from 10 to 50 µm, preferably from 15 to 40 µm, or from 20 to 35 µm, each determined in a cross-sectional view of the wire. The initial thickness is to be understood as the thickness of the wire which is provided during the wedge-bonding process, i.e. the thickness of the coating of the free wire. Preferably, the initial thickness is homogeneous in a cross-sectional view of the wire perpendicular to the longitudinal axis of the wire. A homogeneous thickness may be understood as a thickness which does not deviate by more than 5 %.

In preferred embodiments, the first thickness is smaller than the initial thickness and the second thickness is higher than or equal to the initial thickness.

Preferably, the coating layer in the at least one free section of the bonded wire has a thickness in the range of in the range of 5 to 60 µm, preferably from 10 to 50 µm, preferably from 15 to 40 µm, or from 20 to 35 µm, each determined in a cross-sectional view of the free section of the wire. The aforementioned criteria for thickness of the coating layer should be met within at least 80 %, preferably 90 % of the longitudinal extension of the wire. Preferably, the thickness of the coating layer of the free section or the free sections is homogeneous in a cross-sectional view of the wire perpendicular to the longitudinal axis of the wire.

In preferred embodiments, the first thickness is smaller than the thickness of the coating layer in the free section or the free sections of the bonded wire and the second thickness is higher than or equal to than the thickness of the coating layer in the free section or the free sections of the bonded wire.

Another aspect of the invention is a process for manufacturing an electronic assembly according to the previous aspect of the invention comprising the steps of
I.) providing an electronic element with a contact surface;
II.) providing a wire, wherein the wire comprises
   (i) a copper core with a surface, wherein the copper core has a diameter in the range of 70 to 500 µm, and wherein the aspect ratio between the shortest path and the longest path through the copper core in a cross-sectional view is in the range of 0.8 to 1.0, and
   (ii) a coating layer superimposed over the surface of the copper core, wherein the coating layer comprises silver;
III.) bonding the wire to the contact surface of the electronic element by wedge bonding in a contact area of the contact surface, whereby a bonded wire with at least a bonded section in the contact area and a free section is obtained;

wherein the aspect ratio between the shortest path and the longest path through the copper core of the wire in the bonded section and the free section in a cross-sectional view is in the range of 0.8 to 1.0,
wherein in a cross-section of the contact area perpendicular to the longitudinal length of the bonded wire
the coating of the bonded wire has a first thickness T₁ and a second thickness T₂ along an axis A through the center of the copper core perpendicular to the contact surface in the bonded section,
wherein the first thickness T₁ is the thickness of the coating in contact with the contact surface in the contact area along said axis and the second thickness T₂ is the thickness on the opposite side of the copper core of said axis in a direction from the contact area to the copper core, wherein the first thickness T₁ is smaller than the second thickness T₂.

Aspects of the invention directed to the previously described electronic assembly are also preferred aspects of the electronic assembly obtained by aforementioned process for manufacturing an electronic assembly.

Another aspect of the invention is a device which comprises at least one electronic assembly as described above, preferably the device is an electronic motor, an electronic vehicle, a solar cell or a wind turbine.

The following schematic drawings show aspects of the invention for improving the understanding of the invention in connection with some exemplary illustrations. It should be understood, however, that the invention is not limited to the precise arrangements and instrumentalities shown. The elements of the drawings are not necessarily to scale relative to each other. Like reference numerals designate corresponding similar parts. Herein
- Figure 1: shows a wire;
- Figure 2: shows a cross-sectional view of a wire;
- Figure 3: shows a cross-sectional view of a wire comprising an intermediate layer;
- Figure 4: shows a process according to the invention;
- Figure 5: shows an electronic assembly comprising two electronic elements and a wire;
- Figure 6: shows an electronic assembly comprising five electronic elements and four wires;
- Figure 7: shows a cross-sectional view of an electronic assembly with a bonded wire;
- Figure 8: shows a cross-sectional view of the bonded section of a bonded wire.

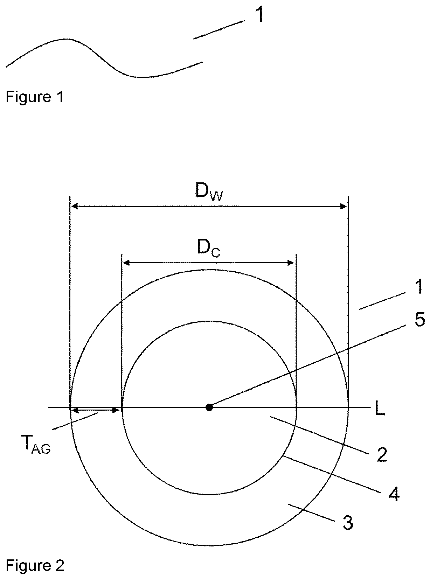

In Figure 1, a wire 1 is depicted.

Figure 2 shows a cross sectional view of wire 1. The copper core 2 is encompassed by a coating layer 3. The surface 4 of the core is located on the limit of copper core 2. On a line L through the center 5 of the copper core 2 the diameter of copper core D_{C} 2 is shown as the end to end distance between the intersections of line L with the surface 4. The diameter D_{W} of wire 1 is the end-to-end distance between the intersections of line L through the center 5 and the outer limit of wire 1. Besides, the thickness of coating layer 3 T_{AG} is depicted.

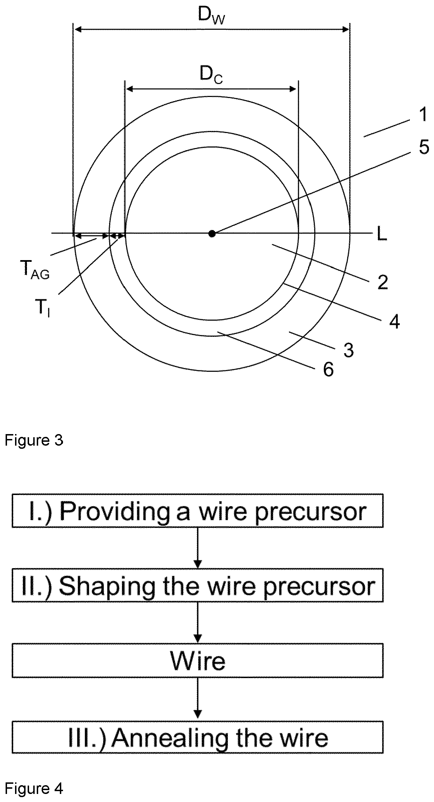

In Figure 3, a wire 1 having a copper core 2, an intermediate layer 6 and a coating layer 3 is depicted. In addition to the items described for Figure 2, the thickness T_{I} of the intermediate layer 6 is shown.

Figure 4 shows a process to manufacture a wire according to the invention.

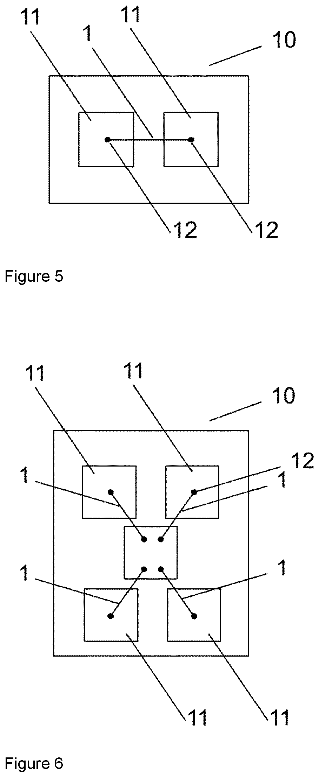

Figure 5 depicts an electronic module 10 comprising two electronic elements 11 and a wire 1. The wire 1 electrically connects the two electronic elements 11 via wedge bonds 12. One of the electronic elements 11 may be a semiconductor, which is connected via the bonding wire 1 to a substrate.

Figure 6 depicts another electronic module 10. Five electronic elements 11 are electrically connected by four wires 1. Only one of the eight wedge bonds 12 is assigned with a reference number for better clarity.

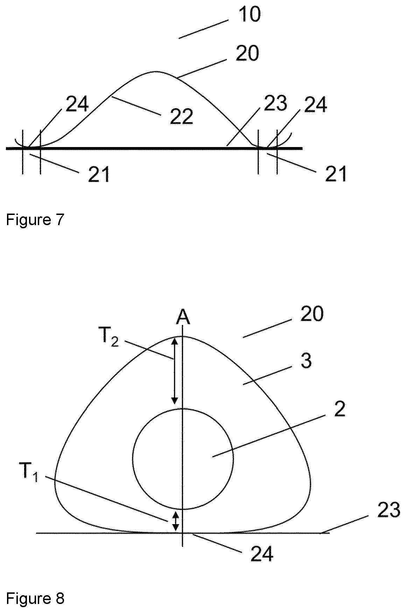

Figure 7 shows a cross-sectional view of an electronic module 10 with a bonded wire 20. The bonded wire 20 is wedge-bonded in two bonded sections 21 to contact areas 24 of the contact surface 23 of the electronic module 10. The section of the bonded wire between the bonded sections is not bonded to the electronic module, i.e. the bonded wire 20 comprises a free section 22.

Figure 8 shows a cross-sectional view of the bonded section 21 of a bonded wire 20. The bonded wire 20 comprises a round copper core 2 which is enclosed in a silver coating layer 3. The section of the silver coating layer 3 which is in the center of the contact area has a thickness T₁ along a central axis A through the copper core 2 and a higher second thickness T₂ on the opposite side of the axis A.

### Test Methods

All tests and measurements were conducted at T = 20 °C and a relative humidity of 50 %.

### Layer Thickness

For determining the thickness of the coating layer, the thickness of the intermediate layer and the diameter of the core, the wire was cut perpendicular to the maximum elongation of the wire. The cut was carefully grinded and polished to avoid smearing of soft materials, e.g. Ag. A picture was recorded through an optical microscope or a scanning electron microscope (SEM), wherein the magnification is chosen so that the full cross-section of the wire is shown.

This procedure was repeated at least 15 times. All values are provided as arithmetic mean of the at least 15 measurements.

The invention is further exemplified by a representative example. These example serves for exemplary elucidation of the invention and is not intended to limit the scope of the invention or the claims in any way.

A wire precursor with a diameter of 0.4 mm having a copper core with a diameter of 300 µm and a 50 µm thick electroplated silver coating was elongated using 5 drawing dies to obtain a wire with a diameter of 300 µm. Then, the elongated wire was put on a metal spool and annealed in an oven for 1 hour at an annealing temperature of 350 °C. After annealing, the wire was cooled to ambient temperature within 5 hours. The wire obtained had a coating layer with a final thickness of 10 µm and an intermediate layer with a thickness of 0.1 µm.

Relevant bonding parameters and characteristics of the inventive wire (Ag coated Cu wire) according to the example were compared with commonly used bonding wires with a diameter of 300 µm (Al wire, Cu wire, Al coated Cu wire with an AI coating layer of 25 µm). The wires were wedge bonded on different substrates and the quality of the obtained bonds was evaluated. The temperature stability was tested by exposure of the bonded wire to the respective temperature and evaluating the time toto failure of the bond. Gate bonding on small gate pad was evaluated and the corrosion resistance was evaluated with regard to the thermal stress resistance during use.

A qualitative comparison of the results is summarized in Table 1. Hereby
- ++: indicates high suitability of performance or no/very late failure;
- +: indicates general suitability of performance or late failure;
- 0: indicates average performance;
- -: indicates low performance or early failure;
- *--*: indicates no suitability of performance or very early failure.

**Table 1.**

| | Al Wire | Cu Wire | Al coated Cu wire | Ag coated Cu wire |
|---|---|---|---|---|
| Bonding on standard Si dies | ++ | -- | ++ | ++ |
| Bonding on SiC dies | ++ | -- | ++ | ++ |
| Bonding on GaN dies | ++ | -- | ++ | ++ |
| Temperature stability ≤ 150°C | ++ | ++ | ++ | ++ |
| Temperature stability ≤ 175°C | o | ++ | ++ | ++ |
| Temperature stability ≤ 200°C | -- | ++ | o | ++ |
| Gate bond on SiC dies | -- | -- | ++ | ++ |
| Corrosion resistance | o | + | o | ++ |

The performance parameters of the Ag coated Cu wire would in general be comparable to a pure Ag wire, but the costs are significantly lower.

### Reference Signs

- (1): wire
- (2): copper core
- (3): coating layer
- (4): surface of copper core
- (5): center of copper core
- (6): intermediate layer
- (10): electronic assembly
- (11): electronic element
- (12): wedge bond
- (20): bonded wire
- (21): bonded section of bonded wire
- (22): free section of bonded wire
- (23): contact surface
- (24): contact area
- L: Line
- D_{W}: Diameter of wire
- D_{C}: Diameter of copper core
- T_{AG}: Thickness of silver coating
- T_{I}: Thickness of intermediate layer
- A: Axis through copper core of bonded wire
- T₁: First thickness of coating layer of bonded wire
- T₂: Second thickness of coating layer of bonded wire

## Claims

1. A wire comprising:
(i) a copper core with a surface; and
(ii) a coating layer superimposed over the surface of the copper core,
wherein the coating layer comprises silver;
wherein the aspect ratio between the shortest path and the longest path through the wire in a cross-sectional view is in the range of 0.8 to 1.0,
wherein the wire has a diameter in the range of 100 µm to 600 µm and
wherein the area share of the coating layer in a cross-sectional view of the wire is in the range of 10 to 60 %, based on the total area of the cross-section of the wire.

2. A wire according to claim 1, wherein the copper core a comprises at least 95 % by weight of elemental copper (Cu), based on the total weight of the copper core.

3. A wire according to claim 1 or 2, wherein the copper core comprises less than 100 ppm or further components.

4. A wire according to any of the preceding claims, wherein the diameter of the copper core is in the range of 70 to 500 µm.

5. A wire according to any of the preceding claims, wherein the coating layer comprises at least 85 % by weight of elemental silver (Ag), based on the total weight of the coating layer.

6. A wire according to any of the preceding claims, wherein the thickness of the coating layer is in the range of 5 to 60 µm.

7. A wire according to any of the preceding claims, wherein an intermediate layer is arranged between the copper core and the coating layer.

8. A wire according to claim 7, wherein the intermediate layer comprises only material of the copper core and material of the coating layer.

9. A wire according to claim 7 or 8, wherein the intermediate layer has a thickness in the range of 0.1 to 5 µm.

10. A process for manufacturing a wire according to claims 1 - 9, comprising at least the following steps:
I.) providing a wire precursor comprising a copper core precursor with a surface and a coating layer precursor, which coating layer precursor is superimposed over the surface of the copper core precursor, wherein the coating layer precursor comprises silver,
wherein in a cross-sectional view of the wire precursor the area share of the coating layer precursor is in the range of 10 to 60 %, based on the total area of the cross-section of the wire precursor, and
wherein the aspect ratio between the shortest path and the longest path through the wire precursor in a cross-sectional view is in the range of 0.8 to 1.0;
II.) shaping the wire precursor, whereby the wire is obtained.

11. An electronic assembly comprising at least a wire according to any of claims 1 - 9 or a wire manufactured according to claim 10.

12. An electronic assembly according to claim 11, wherein the wire is bonded by wedge-wedge bonding.

13. A process for manufacturing an electronic assembly comprising the steps of
I.) providing at least two electronic elements;
II.) providing a wire according to any of claims 1 - 9 or obtained by a method according to claim 10;
III.) connecting the two electronic elements through the wire, wherein at least one of said connections is performed by wedge bonding.

14. An electronic assembly, comprising an electronic element with a contact surface and at least a bonded wire, which is wedge-bonded to the contact surface in a contact area, wherein the bonded wire comprises
(i) a copper core with a surface, wherein the copper core has a diameter in the range of 70 to 500 µm; and
(ii) a coating layer superimposed over the surface of the copper core, wherein the coating layer comprises silver;
wherein the wire comprises at least one bonded section in the contact area and at least one free section, and
wherein the aspect ratio between the shortest path and the longest path through the copper core of the wire in the bonded section and the free section in a cross-sectional view is in the range of 0.8 to 1.0,
wherein in a cross-section of the contact area perpendicular to the longitudinal length of the bonded wire the coating layer of the bonded wire has a first thickness T₁ and a second thickness T₂ along an axis A through the center of the copper core perpendicular to the contact surface in the bonded section,
wherein the first thickness T₁ is the thickness of the coating layer in contact with the contact surface in the contact area along said axis and the second thickness T₂ is the thickness of the coating layer on the opposite side of the copper core of said axis in a direction from the contact area to the copper core,
wherein the first thickness T₁ is smaller than the second thickness T₂.

15. An electronic assembly according to claim 14, wherein the first thickness T₁ is smaller than the thickness of the coating layer in the free section or the free sections of the bonded wire and the second thickness T₂ is higher than or equal to the thickness of the coating layer in the free section or the free sections of the bonded wire.
